(19) 

**Europäisches Patentamt**

**European Patent Office**

**Office européen des brevets**

(11) **EP 3 783 547 B1**

(12) **EUROPEAN PATENT SPECIFICATION**

(45) Date of publication and mention
of the grant of the patent:
**22.02.2023 Bulletin 2023/08**

(21) Application number: **20161146.4**

(22) Date of filing: **05.03.2020**

(51) International Patent Classification (IPC):
*G06Q 10/04* (2012.01)     *G06Q 10/06* (2012.01)
*G06Q 10/08* (2012.01)

(52) Cooperative Patent Classification (CPC):
**G06Q 10/04; G06Q 10/06; G06Q 10/08**

(54) **SYSTEM AND METHODS FOR REPLY DATE RESPONSE AND DUE DATE MANAGEMENT IN MANUFACTURING**

SYSTEM UND VERFAHREN FÜR ANTWORTDATUM-ANTWORT UND FÄLLIGKEITSVERWALTUNG IN DER FERTIGUNG

SYSTÈME ET PROCÉDÉS POUR RÉPONDRE À UNE RÉPONSE DE DATE ET DE GESTION DE DATE D'ÉCHÉANCE DANS LA FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.08.2019 US 201916547349**

(43) Date of publication of application:
**24.02.2021 Bulletin 2021/08**

(73) Proprietor: **Hitachi, Ltd.**
**Tokyo 100-8280 (JP)**

(72) Inventors:
• **SERITA, Susumu**
**Santa Clara, CA California 95054 (US)**

• **GUPTA, Chetan**
**Santa Clara, CA California 95054 (US)**

(74) Representative: **MERH-IP Matias Erny Reichl Hoffmann**
**Patentanwälte PartG mbB**
**Paul-Heyse-Strasse 29**
**80336 München (DE)**

(56) References cited:
**WO-A1-2019/040999     WO-A2-2016/207901**
**US-A1- 2018 374 017**

**Description**

**BACKGROUND**

Field

The present disclosure is generally related to manufacturing systems, and more specifically, to facilitating reply date response and due date management in manufacturing systems.

Related Art

Due date quotation is a key activity in factories and manufacturing systems, especially with make-to-order implementations since the due date affects production schedule and customer satisfaction. When a factory receives an order from a customer, the factory management system replies with a due date to the customer based on the shop floor capacity, and generates a job for execution on the production lines to fulfill the order. In such cases, a job is an instance which can undergo multiple processes to produce a final product. Usually, factories have an internal policy or rule to decide a due date. Earlier due date quotations can satisfy the customer, but the risk of past due delivery increases.

Another key activity in factories and manufacturing systems is production scheduling, which decides the processing timing of such jobs. More precisely, the production scheduling specifies when and by which machine in the factory each job is processed. For situations in which the factory resources, machines, and operators are limited, the production scheduling can have a critical impact on the production cycle time. Similar to the due date quotation, factories can have na internal policy or rule to decide the production schedule. If the overall cycle time can be shortened by appropriate scheduling, the risk of past due delivery decreases.

Related art implementations involve methods for generating due date replies based on the result of a factory emulation which vertically simulates production lines. However, it is not possible to simulate all the possible cases in the future. Even in a case that simulation covers only a subset of possible cases, the computation required is large and it can be difficult for such related art implementations to generate a due date reply within a desired period of time.

In related art implementations, there are methods that estimate a lead time based on a machine learning model and use the estimation result to generate the due date reply. A benefit of the related art implementation is that the computation time can be reduced. However, such related art implementations assumes that production scheduling rules are fixed to estimate the lead time.

In related art implementations, there is a method that searches the optimal production scheduling. Basically, such related art implementations search the optimal policy under the situation that due dates are given. Thus, searching an optimal due date requires a scheduling policy in advance, and scheduling requires a due date assignment policy in advance. Due date quotation and scheduling are mutually dependent. To obtain good policies for both the due date and the scheduling, the two solutions need to be considered simultaneously. Furthermore, WO 2019/040999 A1 discloses a network scheduling and tracking control system, wherein a server is configured for calculating a predicted work time for each of the shipments in accordance with a respective predicted transit time and a respective predicted handling time and wherein the server is configured for scheduling the shipments at least according to the predicted work time. WO 2016/207901 A1 discloses a system and method for real time scheduling for transportation planning and allocation of resources.

**SUMMARY**

In the related art, there is no implementation in the related art that considers due date and scheduling together. Example implementations are directed to determining a policy for due date assignment and scheduling together (e.g., simultaneously).

To solve the problem described above, example implementations described herein involve a virtual environment which simulate the factory production lines and order arrivals. The example implementations learn the policy for due date quotation and scheduling through trials of decisions made on the virtual environment. Due date quotation and scheduling processes are modeled as a collaborative decision making process, wherein the example implementations search the optimal policies by updating both policies simultaneously based on the feedback in a simulation environment. The feedback reflects on how each decision was (e.g., better/worse) in terms of a target metric to be improved on, such as tardiness. After learning the due date quotation and scheduling policies on the virtual environment, the policies are installed on the actual operation system. The policies thereby facilitate a factory or manufacturing system to execute an appropriate decision in a real time fashion.

The present invention is set out in the appended set of claims. Preferable embodiments are claimed by the dependent claims.

## BRIEF DESCRIPTION OF DRAWINGS

FIG. 1 illustrates an example scope of operations to which the example implementations described herein are targeted.

FIG. 2 illustrates an example of the system architecture, in accordance with an example implementation.

FIG. 3 illustrates an example of the flow chart to learn policies for a due date quotation policy and scheduling in DDPS Optimization module, in accordance with an example implementation.

FIG. 4 illustrates how two agents learn the policies through the interaction with the simulation environment, in accordance with an example implementation.

FIG. 5 illustrates an example of the dashboard for due date quotation operation, in accordance with an example implementation.

FIG. 6 illustrates an example of the dashboard for production scheduling operation, in accordance with an example implementation.

FIG. 7 illustrates an example physical structure of the system, in accordance with an example implementation.

FIG. 8 illustrates an example computing environment with an example computer device suitable for use in some example implementations.

## DETAILED DESCRIPTION

The following detailed description provides further details of the figures and example implementations of the present application. Reference numerals and descriptions of redundant elements between figures are omitted for clarity. Terms used throughout the description are provided as examples and are not intended to be limiting. For example, the use of the term "automatic" may involve fully automatic or semi-automatic implementations involving user or administrator control over certain aspects of the implementation, depending on the desired implementation of one of ordinary skill in the art practicing implementations of the present application. Selection can be conducted by a user through a user interface or other input means, or can be implemented through a desired algorithm. Example implementations as described herein can be utilized either singularly or in combination and the functionality of the example implementations can be implemented through any means according to the desired implementations.

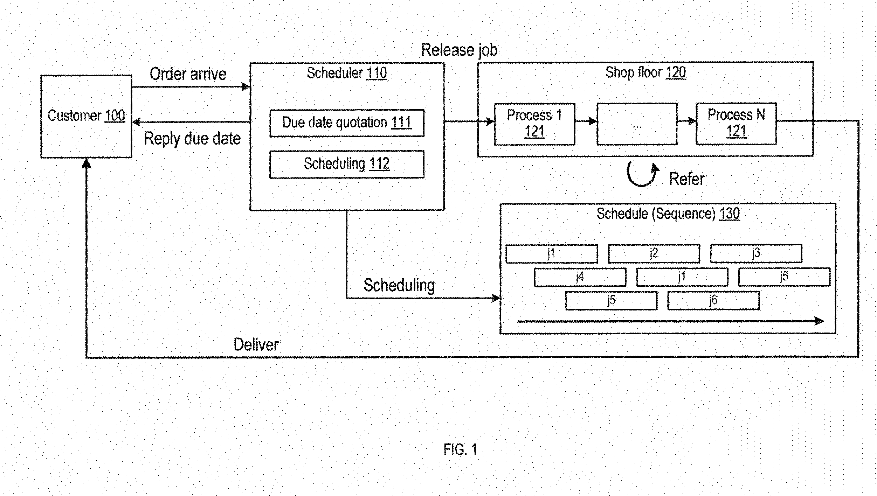

FIG. 1 illustrates an example scope of operations to which the example implementations described herein are targeted. When an order arrives from a customer 100, a scheduler 110 needs to quote a due date for the order and replay the date to the customer through using a due date quotation function 111. The scheduler 110 also manages scheduling 112, which decides when each job is operated on each process in the shop floor 120. Orders can arrive one after another, however, the scheduler 110 does not necessarily know about the order information until it actually arrives. Once the scheduler 110 replies with a due date to the customer 100, a job is issued for the order and released to the shop floor 120. A series of processes 121 is applied to a job to make a final product, the processes 121 applied according to the schedule 130. The schedule 130 indicates the sequence and timing of processes 121 to be executed. The process flow depends on the product. Different final products have different flows in terms of processes and processing times.

Table 1 shows an example of associations between a product and a process flow. For example, to make product Prd0011, process P010 is executed for 10 minutes first, P020 is executed for 15 min, and so on. In example implementations, it can be assumed that there are multiple machines to operate a particular process and a machine can be shared across the multiple processes, but only one process can use a machine at the same time. This assumption fits the traditional job shop processes, however, the example implementations are not limited to job shop process and can be extended to other processes in accordance with the desired implementation. For example, the example implementations can be applied to flow shop processes.

### Table 1 Processes required

| Product | Process Name (Process time) |
| --- | --- |
| Prd0011 | P010 (10) > P020 (15) > P030 (5) > P040 (10) > P070 (5) > P80 (5) >P110 (10) |

(continued)

| Product | Process Name (Process time) |
|---------|------------------------------|
| Prd0012 | P010 (10) > P030 (5) > P050 (10) > P040 (10) |
| Prd0013 | P010 (10) > P020 (15) > P050 (5) > P060 (10) > P070 (5) > P80 (5) >P100 (10) |
| Prd0014 | P030 (10) > P020 (15) > P050 (5) > P060 (10) > P070 (5) > P80 (5) >P110 (10) |
| ... | ... |

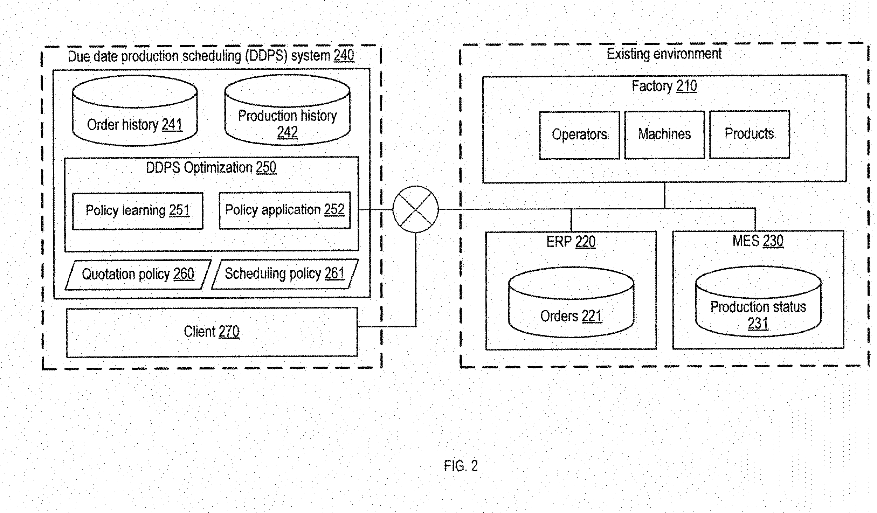

FIG. 2 illustrates an example of the system architecture, in accordance with an example implementation. Example implementations can provide due date and scheduling management (DDSM) system on top of an existing system in a factory 210. In example implementations, it is assumed that a factory 210 manages customer orders 221 with a computer system that facilitates functionality for an Enterprise Resource Planning (ERP) system 220. It is also assumed that a factory traces its production status 231 and instructs the operations through a computer system, which is a common function of Manufacturing Execution System (MES) 230.

Due date production scheduling (DDPS) system 240 stores history data in a factory about orders 241 and production status 242, which facilitates the DDPS to build a simulation model that reproduces the events in the past. DDPS optimization module 250 provides a function to learn policies 251 for due date quotation and scheduling in simulation environment. DDPS also provides a function to apply learned policies 252 to the existing system.

Quotation policy 260 provides a function that takes an order information and current production status as input, and outputs a due date which should be replied to the customer when a factory received a new order. Scheduling policy 261 provides a function that takes current production status as input and outputs a dispatching decision. A dispatching decision decides which job in a queue is going to be operated by a machine available. The timing of the decisions depends on the desired implementation of the method. For example, the method can be implemented in a way that allows a scheduler to make a decision periodically according to a pre-set interval (e.g. every 10 min). Another option is to make a decision only when a particular event happens. An event can be finishing a job on a machine and the machine becomes available. In either case, the policy decides which job should be operated on a particular machine taking into account the current production status. Such learned policies are applied to an actual factory operation through an existing system such as ERP 220 and MES 230.

Table 2 illustrates an example of order information 221. Order identifier (ID) indicates a unique identification of the order. Customer indicates who requested the order. Product indicates the final product that the customer requested, which can be described by product type, product name, or product number, in accordance with the desired implementation. Quantity indicates the amount the customer requested for the product. In situations where that customer can request the preferred due date, the order information can include such information. Further, in situations where a customer cannot provide a preferred due date, example implementations can assume an earlier due date is preferable. Order information 221 can include additional information about the order (e.g., size of the product) and can be modified in accordance with the desired implementation. In a typical factory, ERP system 220 manages the information described in Table 2.

**Table 2 Order information**

| Order ID | Customer | Product | Quantity | Requested Due | Size | ... |
|----------|----------|---------|----------|---------------|------|-----|
| US-2018-01103 | A | Prd0032 | 100 | 2019/09/20 | Large | ... |

Table 3 illustrates an example of production status 231. Order ID is an ID as stored in order information 221. A typical factory issues job(s) as a unit of operation in production lines and associates the job(s) with a customer order. Without loss of generality, example implementations use the order ID to describe the jobs. Quoted due is a due date the factory replied to the customer as a result of due date quotation. Process represents the current stage in which the job is positioned. Status shows the current status of the job (e.g., waiting the operation, operation is working by a machine, etc.). Machine gives the machines which are able to operate the job once they become available, or a machine which currently operating on the job. In this example, the job associated with order US_2018-01103 has to be delivered by 2019/09/22 and currently it's waiting for an operation of P010 by a machine M011. In a typical factory, the information described here is managed by MES 230.

**Table 3 Production status**

| Order ID | Quoted due | Process | Status | Machine | ... |
|----------|-----------|---------|--------|---------|-----|
| US_2018-01103 | 2019/09/22 | P010 | Wait | M011 | ... |
| US-2018-01104 | 2019/09/20 | P020 | Work | M021 | ... |
| US-2018-01105 | 2019/10/01 | P010 | Wait | M011 | ... |
| ... | ... | ... | ... | ... | ... |

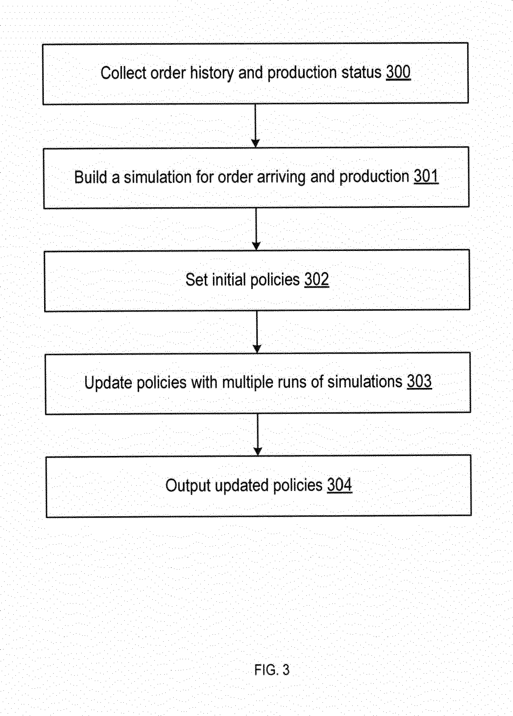

FIG. 3 illustrates an example of the flow chart to learn policies for a due date quotation policy and scheduling in DDPS Optimization module, in accordance with an example implementation.

At 300, the module collects historical data of orders and production status. This can be done by transferring batched data from the ERP and MES system, or by fetching snapshots in a real time fashion from those systems and storing the snapshots for a certain period. The required period of historical data depends on the variety of the customer orders and productions, and can be adjusted accordingly to fit the desired implementation.

At 301, the module builds a simulation environment of order arriving and production lines with a discrete-event simulation (DES). A DES is a general tool to simulate stochastic discrete events and widely used to simulate discrete processes in manufacturing lines. With sufficient knowledge regarding the production lines including the process flow described in Table 1 and a list of machines, example implementations can thereby construct a simulator that virtually generates events in production lines. The events include job arrivals in a process, starting operation, finishing operation, and so on. From historical order information, example implementations can extract order trends such as arriving rate of order in terms of product, quantity, and requested due date. The extracted trends are fed to the simulator to generate virtual orders which reflects the actual order trends. The simulator built at this stage is used to learn the policies.

At 302, DDPS sets initial policies. DDPS should start with some baselines as DDPS has not learned policies yet at this point. Example implementations can use a random policy as an initial baseline which outputs a random decision regardless of a current state, and such a baseline can include order information and production status. In another example implementations, policies which are actually used in the factory can be utilized as the baseline. For example, the factory may have a rule that a due date is set ten days later from they receive an order. That rule is used as an initial policy for due date quotation. The factory may have a rule that a job is selected from the queue in a process according to the first-in-first-out (FIFO) rule. In such a case, that rule is used as an initial policy for scheduling.

At 303, DDPS continuously update the policies through multiple runs of the simulation. The simulator generates virtual orders based on the trends extracted at 301. Each time the simulator issues an event such as order arriving and machine becoming available, the DDPS module makes a decision based on current policies. Then, the simulator advances the clock and generates the next event based on the decision taken. The simulation result gives the DDPS feedback regarding how good or bad the current situation is. A feedback is quantified by metrics described in the following session. Once DDPS receives feedback, DDPS updates the policies based on it. This update process can be done following the framework known as Reinforcement Learning, one of the machine learning methods.

At 304, DDPS module outputs the policies learned at the previous step.

The detail of the mechanism to update due date quotation and scheduling policies is as follows. As mentioned previously, DDPS module uses reinforcement learning (RL) to update the policies. RL defines an agent, which is a subject taking an action according to the policy and interacting with an environment. DDPS defines two types of agents; one for due data quotation and the other for scheduling.

RL represents the current situation with a state. DDPS represents a state by two factors; an order state $S_j$ for order $j$ and $S_g$ for a global shop floor state. $S_j$ includes product, quantity, requested due, and so on. $S_g$ can include work in process, which represents how many jobs are stuck at each process, working jobs in each machine, and so on. For later use, the notations for key definitions are summarized as follows.

$j$ : Job index

$r_j$ : Arrival time of job $j$

$d_j$ : Quoted due date of job $j$

$C_j$ : Complete time of job $j$

$a_j$ : Requested due date of job $j$

$E_j$ = max $(0, d_j - C_j)$ : Earliness of job j

$T_j$ = max $(0, C_j - d_j)$ : Tardiness of job j

$L_j = d_j - r_j$ : Lead time of job j

$D_j$ = max $(0, d_j - a_j)$ : Delay of job j

An agent has a policy, which maps states to actions. DDPS defines two types of actions based on the agent types. An action of due date quotation agent is to select a due date $d_j$ given a new order. One way to formalize the policy for due date quotation is to introduce lead time estimation function $f(s_j, s_g; \theta_q)$, which estimates how long it takes to finish the order $j$ at state $S_g$. $\theta_q$ is a set of parameters which decides the function. The due date $d_j$ is given by

$$d_j = r_j + f(s_j, s_g; \theta_q)$$

where $r_j$ is a date order $j$ arrives. An action of scheduling agent is to select the next job to be operated on a machine available at that moment. One way to formalize the selection is to introduce job priority function $g(s_j, s_g; \theta_s)$, which assigns a weight on job (order) $j$ given a shop floor state $S_g$. $\theta_s$ is a set of parameters which decides the function for the job priority function. Given a list of jobs in a queue, the agent selects the next job with highest weight among them according to the priority function. Mathematically,

$$\mathrm{argmax}_j g(s_j, s_g; \theta_s)$$

is selected as the next job, where $j$ takes any order in a queue.
RL receives a feedback from an environment as a reward. There are several options to define the reward for DDPS agents. If there is no room for the customer to request a due date by themselves, the cost function can be defined as follows:

$$\omega_L L_j + \omega_E E_j + \omega_T T_j$$

where $\omega_L$, $\omega_E$, $\omega_T$ are constants defined in advance. The first term represents the time between the order arriving and the quoted date. Smaller values indicate that the quoted date is close to the arrival date, in other words, the customer waiting time is short. The last two terms represent the difference between the quoted due date and actual delivery date. Smaller values indicate that the delivery date is close to the date the factory promised. In summary, making the cost function smaller means promising the earlier date and delivery without delay or earliness.
If a customer can request a due date, a cost function can be formalized considering that requested date as follows:

$$\omega_D D_j + \omega_E E_j + \omega_T T_j$$

where $\omega_D$, $\omega_E$, $\omega_T$ are constants defined in advance. The first term represents the time between the due date the customer requested and the quoted date. This quantifies how much the due date meets the customer's preference. The rest of the terms are the same as the previous case. By taking a negative of the cost functions, we can convert the cost functions to rewards.

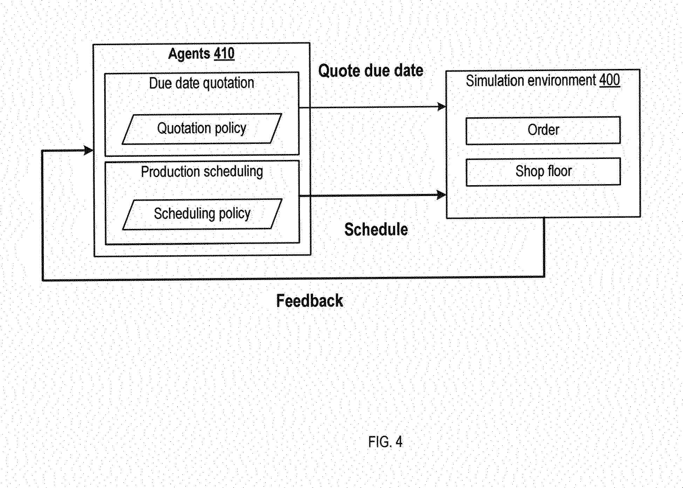

FIG. 4 illustrates how two agents learn the policies through the interaction with the simulation environment, in accordance with an example implementation. Whenever the simulator 400 issues an event related to the due date quotation or job dispatch, the relevant agent 410 takes an action based on the current policy. The action taken changes the state of the environment in the simulation environment 400 and generates the feedback. Based on the reward, the agents update their policies. Sharing the same reward allows the agents to update their policy towards the same goal.
As described below, learned policies are used to make decisions on actual factory operations. Once the DDPS module learns policies for due date quotation and scheduling, the policy application module integrates learned policies with existing systems. One way of the integration is via a dashboard system that allows a scheduler to see the result of recommended action and make actual decisions through existing system such as ERP, MES.

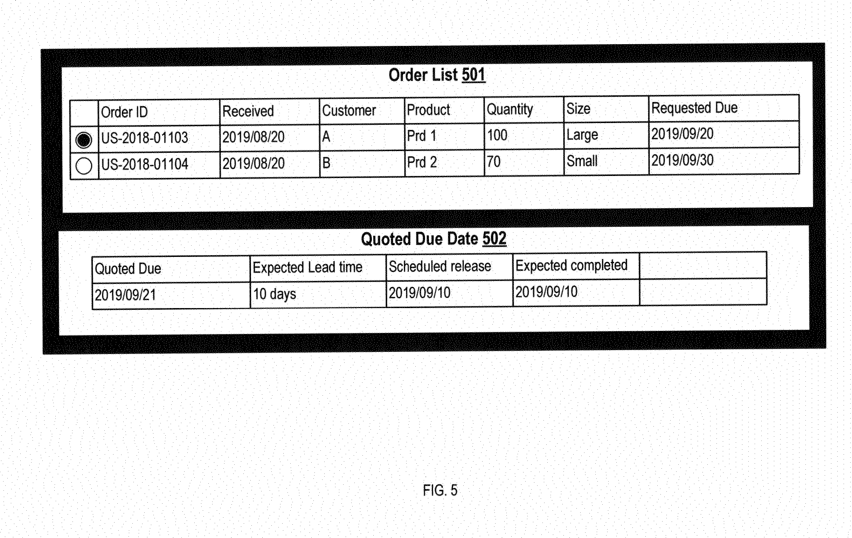

FIG. 5 illustrates an example of the dashboard for due date quotation operation, in accordance with an example implementation. The top panel 501 provides a list of orders which arrive at the factory and need to be quoted, along with relevant information. When the scheduler selects an order, the application module extracts job information as well as current production status from existing systems and convert them into a form to which the learned policy can be applied. Then, the application module applies the policy to get the quoted due date. The result is shown in the bottom panel 502.

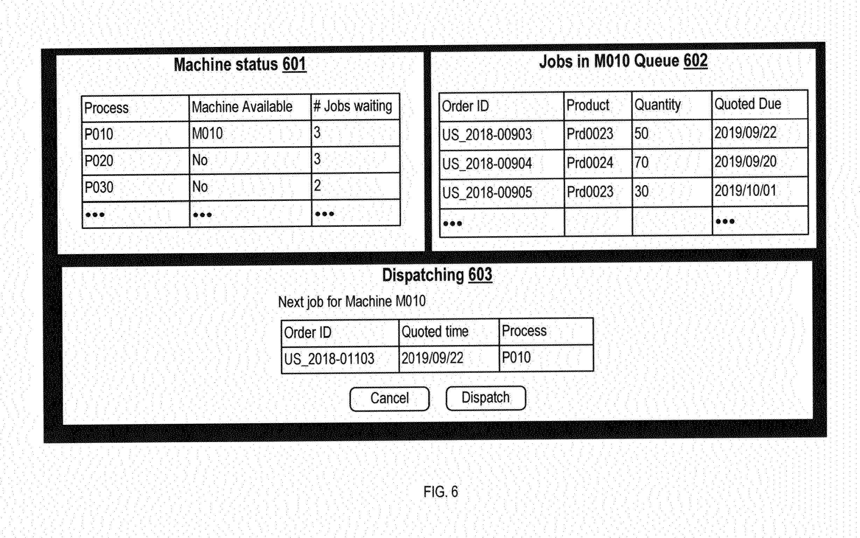

FIG. 6 illustrates an example of the dashboard for production scheduling operation, in accordance with an example implementation. The top left panel 601 shows machine status in a factory. When the scheduler selects a process waiting for an assignment of the next job, the jobs in that process appear in the top right panel 602. The application module extracts current production status and applies the policies learned. The output result of the next job is shown in bottom panel 603. The scheduler can check the output and if there is no problem, the scheduler can then select a dispatch option based on the result. If there is an issue, the scheduler can cancel the option. In either case, the decision is transmitted to the MES 230.

Through the example implementations described herein, policies can be learned for due date quotation and production scheduling simultaneously.

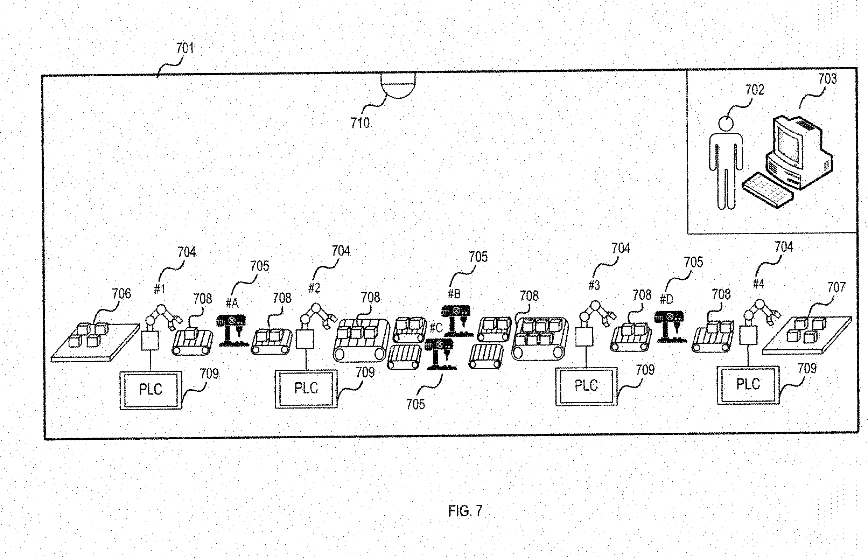

FIG. 7 illustrates an example physical structure of the system, in accordance with an example implementation. In a factory 701, there are lines including one or more machines, such as equipment 705, and robotic arms 704 that are configured to execute manufacturing processes such as loading components, unloading components, assembling components, and so on. For example, example manufacturing processes can involve processes in which equipment 705 processes products 708 and robotic arms 704 carry products 708 in accordance with a schedule. Multiple kinds or types of products may be processed at the same time, depending on the desired implementation. Robotic arms 704 and equipment 705 can be controlled by Programmable Logic Controllers (PLCs) 709. Workers 702 dispatch due date and scheduling policies to computing device 703 which is connected to programmable logic controllers 709. In lines, loading products 706 and unloading products 707 are managed by production management systems, in accordance with an example implementation. Depending on the desired implementation, a camera system 710 may also monitor the factory floor 701.

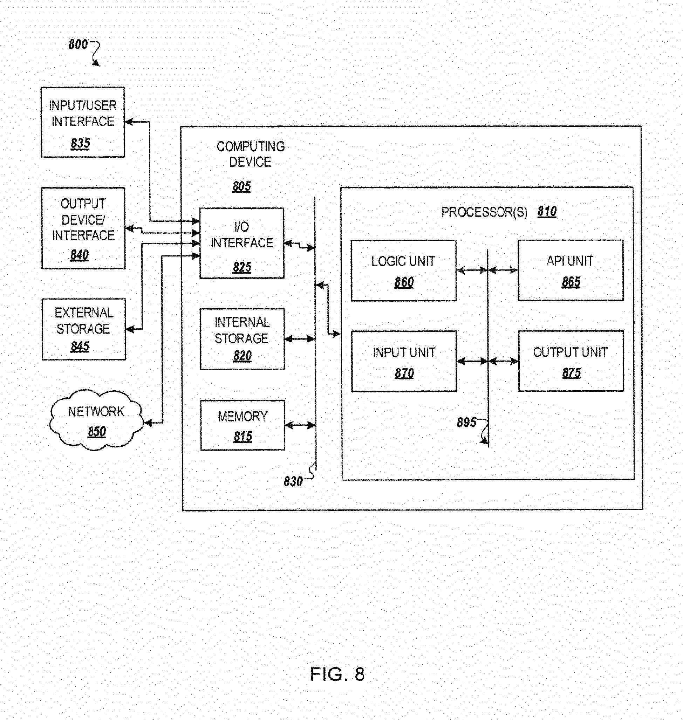

FIG. 8 illustrates an example computing environment with an example computer device suitable for use in some example implementations, such as a computing device 703 as illustrated in FIG. 7 configured to facilitate the system illustrated in FIG. 2 and all the functions therein, and as configured to provide an interface as illustrated in FIGS. 5 and 6. In such an example implementation, the computer device 703 is connected to one or more programmable logic controllers (PLCs) associated with one or more machines on a factory floor over a network as illustrated in FIG. 7.

Computer device 805 in computing environment 800 can include one or more processing units, cores, or processors 810, memory 815 (e.g., RAM, ROM, and/or the like), internal storage 820 (e.g., magnetic, optical, solid state storage, and/or organic), and/or I/O interface 825, any of which can be coupled on a communication mechanism or bus 830 for communicating information or embedded in the computer device 805. I/O interface 825 is also configured to receive images from cameras or provide images to projectors or displays, depending on the desired implementation.

Computer device 805 can be communicatively coupled to input/user interface 835 and output device/interface 840. Either one or both of input/user interface 835 and output device/interface 840 can be a wired or wireless interface and can be detachable. Input/user interface 835 may include any device, component, sensor, or interface, physical or virtual, that can be used to provide input (e.g., buttons, touch-screen interface, keyboard, a pointing/cursor control, microphone, camera, braille, motion sensor, optical reader, and/or the like). Output device/interface 840 may include a display, television, monitor, printer, speaker, braille, or the like. In some example implementations, input/user interface 835 and output device/interface 840 can be embedded with or physically coupled to the computer device 805. In other example implementations, other computer devices may function as or provide the functions of input/user interface 835 and output device/interface 840 for a computer device 805.

Examples of computer device 805 may include, but are not limited to, highly mobile devices (e.g., smartphones, devices in vehicles and other machines, devices carried by humans and animals, and the like), mobile devices (e.g., tablets, notebooks, laptops, personal computers, portable televisions, radios, and the like), and devices not designed for mobility (e.g., desktop computers, other computers, information kiosks, televisions with one or more processors embedded therein and/or coupled thereto, radios, and the like).

Computer device 805 can be communicatively coupled (e.g., via I/O interface 825) to external storage 845 and network 850 for communicating with any number of networked components, devices, and systems, including one or more computer devices of the same or different configuration. Computer device 805 or any connected computer device can be functioning as, providing services of, or referred to as a server, client, thin server, general machine, special-purpose machine, or another label.

I/O interface 825 can include, but is not limited to, wired and/or wireless interfaces using any communication or I/O protocols or standards (e.g., Ethernet, 802.11x, Universal System Bus, WiMax, modem, a cellular network protocol, and the like) for communicating information to and/or from at least all the connected components, devices, and network in computing environment 800. Network 850 can be any network or combination of networks (e.g., the Internet, local area network, wide area network, a telephonic network, a cellular network, satellite network, and the like).

Computer device 805 can use and/or communicate using computer-usable or computer-readable media, including transitory media and non-transitory media. Transitory media include transmission media (e.g., metal cables, fiber optics), signals, carrier waves, and the like. Non-transitory media include magnetic media (e.g., disks and tapes), optical media (e.g., CD ROM, digital video disks, Blu-ray disks), solid state media (e.g., RAM, ROM, flash memory, solid-state storage), and other non-volatile storage or memory.

Computer device 805 can be used to implement techniques, methods, applications, processes, or computer-executable instructions in some example computing environments. Computer-executable instructions can be retrieved from transitory media, and stored on and retrieved from non-transitory media. The executable instructions can originate from one or more of any programming, scripting, and machine languages (e.g., C, C++, C#, Java, Visual Basic, Python, Perl, JavaScript, and others).

Processor(s) 810 can execute under any operating system (OS) (not shown), in a native or virtual environment and can be in the form of physical hardware processors such as Central Processing Units (CPUs) or a combination of software and hardware processors. One or more applications can be deployed that include logic unit 860, application programming interface (API) unit 865, input unit 870, output unit 875, and inter-unit communication mechanism 895 for the different units to communicate with each other, with the OS, and with other applications (not shown). The described units and elements can be varied in design, function, configuration, or implementation and are not limited to the descriptions provided.

In some example implementations, when information or an execution instruction is received by API unit 865, it may be communicated to one or more other units (e.g., logic unit 860, input unit 870, output unit 875). In some instances, logic unit 860 may be configured to control the information flow among the units and direct the services provided by API unit 865, input unit 870, output unit 875, in some example implementations described above. For example, the flow of one or more processes or implementations may be controlled by logic unit 860 alone or in conjunction with API unit 865. The input unit 870 may be configured to obtain input for the calculations described in the example implementations, and the output unit 875 may be configured to provide output based on the calculations described in example implementations.

Memory 815 can be configured to store management information such as that illustrated in Tables 1-3.

Processor(s) 810 can be configured to, in response to an order received by the apparatus such as computing device 703, determine an initial scheduling policy for internal processes to meet the order and a due date policy for the order as illustrated at 302 of FIG. 3; a) execute a simulation involving scheduling decisions and due date quotations based on the initial scheduling policy and the due date policy as illustrated at 303 of FIG. 3; b) execute a machine learning process on results of the simulation to update the scheduling policy and the due date policy by evaluating the scheduling decisions and the due date quotations according to a scoring function which is common for evaluating the scheduling decisions and evaluating the due date quotations as described with respect to reinforcement learning at 303 of FIG. 3 and the reinforcement learning implementations herein; iteratively execute a) and b) until a finalized scheduling policy and the due date policy is determined as illustrated at 303 of FIG. 3 and as illustrated in FIG. 4; and output the finalized scheduling policy and the due date policy in response to the order as illustrated at 304 of FIG. 3 and as illustrated in user interfaces of FIGS. 5 and 6.

As described in FIG, 7, the internal processes can include manufacturing processes, and the processor(s) 810 can be configured to output the finalized scheduling policy and the due date policy in response to the order by responding to the order with the due date policy and dispatching the finalized scheduling policy to the one or more machines to execute a manufacturing process according to the finalized scheduling policy as illustrated in FIG. 5 and FIG. 6, and whereupon when the finalized scheduling policy is determined, it can be dispatched to the one or more machines illustrated in FIG. 7 through the user interface of FIG. 6 via network and PLCs to be executed by the corresponding machines.

The initial scheduling policy is generated from a current production status of the one or more machines of the factory floor associated with the order as described with respect to FIGS. 2 and 3 and as illustrated in Tables 1-3.

As illustrated in FIG. 4, there can be multiple orders issued from multiple agents. Agents can involve external entities (e.g., other computing devices) that submit orders to computing device 703. In such example implementations the simulation can be constructed according to the current outstanding orders as shown at 300 and 301 of FIG. 3 while taking into account the history of orders as described in FIG. 2 and Tables 1-3.

As described with respect to FIG. 3 regarding reinforcement learning implementations, the scoring function can be a cost function that is weighted based on quoted due date and actual delivery date as determined by the simulation.

Depending on the desired implementations, the results of the simulation can involve a state of the order as simulated and a state of the factory floor processing the order as illustrated at 304 of FIG. 3 and FIGS. 5 and 6.

Some portions of the detailed description are presented in terms of algorithms and symbolic representations of operations within a computer. These algorithmic descriptions and symbolic representations are the means used by those skilled in the data processing arts to convey the essence of their innovations to others skilled in the art. An algorithm is a series of defined steps leading to a desired end state or result. In example implementations, the steps carried out require physical manipulations of tangible quantities for achieving a tangible result.

Unless specifically stated otherwise, as apparent from the discussion, it is appreciated that throughout the description, discussions utilizing terms such as "processing," "computing," "calculating," "determining," "displaying," or the like, can include the actions and processes of a computer system or other information processing device that manipulates and transforms data represented as physical (electronic) quantities within the computer system's registers and memories into other data similarly represented as physical quantities within the computer system's memories or registers or other information storage, transmission or display devices.

Example implementations may also relate to an apparatus for performing the operations herein. This apparatus may be specially constructed for the required purposes, or it may include one or more general-purpose computers selectively activated or reconfigured by one or more computer programs. Such computer programs may be stored in a computer readable medium, such as a computer-readable storage medium or a computer-readable signal medium. A computer-readable storage medium may involve tangible mediums such as, but not limited to optical disks, magnetic disks, read-only memories, random access memories, solid state devices and drives, or any other types of tangible or non-transitory media suitable for storing electronic information. A computer readable signal medium may include mediums such as carrier waves. The algorithms and displays presented herein are not inherently related to any particular computer or other apparatus. Computer programs can involve pure software implementations that involve instructions that perform the operations of the desired implementation.

Various general-purpose systems may be used with programs and modules in accordance with the examples herein, or it may prove convenient to construct a more specialized apparatus to perform desired method steps. In addition, the example implementations are not described with reference to any particular programming language. It will be appreciated that a variety of programming languages may be used to implement the teachings of the example implementations as described herein. The instructions of the programming language(s) may be executed by one or more processing devices, e.g., central processing units (CPUs), processors, or controllers.

As is known in the art, the operations described above can be performed by hardware, software, or some combination of software and hardware. Various aspects of the example implementations may be implemented using circuits and logic devices (hardware), while other aspects may be implemented using instructions stored on a machine-readable medium (software), which if executed by a processor, would cause the processor to perform a method to carry out implementations of the present application. Further, some example implementations of the present application may be performed solely in hardware, whereas other example implementations may be performed solely in software. Moreover, the various functions described can be performed in a single unit, or can be spread across a number of components in any number of ways. When performed by software, the methods may be executed by a processor, such as a general purpose computer, based on instructions stored on a computer-readable medium. If desired, the instructions can be stored on the medium in a compressed and/or encrypted format.

Moreover, other implementations of the present application will be apparent to those skilled in the art from consideration of the specification and practice of the teachings of the present application. Various aspects and/or components of the described example implementations may be used singly or in any combination. It is intended that the specification and example implementations be considered as examples only, with the true scope and spirit of the present application being indicated by the following claims.

**Claims**

1. A computer-implemented method for simulating processes in factory production lines, comprising the steps of:

   determining (S300), by a processor (810), a function for internal processes, wherein the function is generated from a current production status of the one or more machines of a factory floor (701),

   a) executing (S301), by the processor (810), a simulation to simulate processing events of the factory production lines with regards to collected historical data,
   b) executing (S302), by the processor (810), multiple runs of a machine learning process with regards to results of the simulation to update the function according to a scoring function, wherein

   the scoring function is a cost function that is weighted based on quoted due date and actual delivery date as determined by the simulation,
   iteratively executing (S303), by the processor (810), the steps a) and b) until a finalized function is determined, wherein the result of each iteration of the simulation is a reward determined by taking a negative of the cost function, wherein the cost function is defined as $\omega_J L_j + \omega_E E_j + \omega_T T_j$, wherein $\omega_J$, $\omega_E$ and $\omega_T$ are constants defined in advance, $L_j$ is a lead time of a job, $E_j$ is an earliness of the job and $T_j$ is a tardiness of the job, and outputting (S304) the finalized function.

**2.** The method of claim 1, wherein

the internal processes are manufacturing processes, and wherein
outputting (S304) the finalized function comprises responding to an order with a due date arrangement and dispatching the finalized function to one or more machines (705) to execute a manufacturing process according to the finalized function.

**3.** The method of 1, wherein
the order comprises multiple orders issued from multiple agents.

**4.** The method of claim 1, wherein
the results of the simulation comprise a state of the order as simulated and a state of a factory floor (701) processing the order.

**5.** A non-transitory computer readable medium, storing instructions for simulating processes in factory production lines, the instructions comprising the steps of:

determining, by a processor (810), a function for internal processes, wherein the function is generated from a current production status of the one or more machines of a factory floor (701),

a) executing, by the processor (810), a simulation to simulate processing events of the factory production lines with regards to collected historical data,
b) executing, by the processor (810), multiple runs of a machine learning process with regards to results of the simulation to update the function according to a scoring function, wherein the scoring function is a cost function that is weighted based on quoted due date and actual delivery date as determined by the simulation,

iteratively executing, by the processor, the steps a) and b) until a finalized function is determined, wherein the result of each iteration of the simulation is a reward determined by taking a negative of the cost function, wherein the cost function is defined as $\omega_J L_j + \omega_E E_j + \omega_T T_j$, wherein $\omega_J$, $\omega_E$ and $\omega_T$ are constants defined in advance, $L_j$ is a lead time of a job, $E_j$ is an earliness of the job and $T_j$ is a tardiness of the job, and
outputting the finalized function.

**6.** The non-transitory computer readable medium of claim 5, wherein

the internal processes are manufacturing processes, and wherein
outputting the finalized function comprises responding to an order with a due date policy and dispatching the finalized function to one or more machines (705) to execute a manufacturing process according to the finalized function.

**7.** The non-transitory computer readable medium of claim 5, wherein
the order comprises multiple orders issued from multiple agents.

**8.** The non-transitory computer readable medium of claim 5, wherein
the results of the simulation comprise a state of the order as simulated and a state of a factory floor (701) processing the order.

**9.** A system, comprising:

one or more machines (705) on a factory floor (701), and
an apparatus communicatively coupled to the one or more machines (705) by one or more Programmable Logic Controllers (PLCs), the apparatus comprising:
a processor (810), configured to:

determine a function for internal processes, wherein the function is generated from a current production status of the one or more machines of a factory floor (701),

a) execute a simulation to simulate processing events of the factory production lines with regards to collected historical data,

b) execute multiple runs of a machine learning process with regards to results of the simulation to update the function according to a scoring function, wherein the scoring function is a cost function that is weighted based on quoted due date and actual delivery date as determined by the simulation,

iteratively execute the steps a) and b) until a finalized function is determined, wherein the result of each iteration of the simulation is a reward determined by taking a negative of the cost function, wherein the cost function is defined as $\omega_J L_j + \omega_E E_j + \omega_T T_j$, wherein $\omega_J$, $\omega_E$ and $\omega_T$ are constants defined in advance, $L_j$ is a lead time of a job, $E_j$ is an earliness of the job and $T_j$ is a tardiness of the job, and output the finalized function.

10. The manufacturing system of claim 9, wherein

the internal processes are manufacturing processes, and wherein
the processor (810) is configured to output the finalized function in response to an order by responding to the order with a due date policy and dispatching the finalized function to the one or more machines (705) to execute a manufacturing process according to the finalized function.

11. The manufacturing system of claim 9, wherein
the order comprises multiple orders issued from multiple agents.

12. The manufacturing system of claim 9, wherein
the results of the simulation comprise a state of the order as simulated and a state of the factory floor (701) processing the order.


**Patentansprüche**

1. Computerimplementiertes Verfahren zum Simulieren von Prozessen in Fabrikfertigungslinien, das die folgenden Schritte umfasst:

Bestimmen (S300) durch einen Prozessor (810) einer Funktion für interne Prozesse, wobei die Funktion aus einem aktuellen Produktionsstatus der einen oder der mehreren Maschinen einer Fabrikhalle (701) erzeugt wird,

a) Ausführen (S301) durch den Prozessor (810) einer Simulation, um die Verarbeitung von Ereignissen der Fabrikfertigungslinien unter Berücksichtigung gesammelter historischer Daten zu simulieren,
b) Ausführen (S302) durch den Prozessor (810) mehrerer Durchläufe eines Prozesses für maschinelles Lernen im Hinblick auf Ergebnisse der Simulation, um die Funktion gemäß einer Bewertungsfunktion zu aktualisieren, wobei

die Bewertungsfunktion eine Kostenfunktion ist, die auf der Grundlage eines angebotenen Fälligkeitstermins und eines tatsächlichen Liefertermins gemäß der Bestimmung durch die Simulation gewichtet ist,
iteratives Ausführen (S303) durch den Prozessor (810) der Schritte a) und b), bis eine endgültige Funktion bestimmt worden ist, wobei das Ergebnis jeder Iteration der Simulation eine Belohnung ist, die durch Bilden eines Negativen der Kostenfunktion bestimmt wird, wobei die Kostenfunktion als $\omega_J L_j + \omega_E E_j + \omega_T T_j$ definiert ist, wobei $\omega_J$, $\omega_E$ und $\omega_T$ Konstanten sind, die im Voraus definiert sind, $L_j$ eine Vorlaufzeit eines Auftrags ist, $E_j$ eine Verfrühung des Auftrags ist und $T_j$ eine Verspätung des Auftrags ist, und
Ausgeben (S304) der endgültigen Funktion.

2. Verfahren nach Anspruch 1, wobei

die internen Prozesse Herstellungsprozesse sind und
das Ausgeben (S304) der endgültigen Funktion ein Antworten auf eine Bestellung mit einer Fälligkeitstermingestaltung und ein Ausliefern der endgültigen Funktion zu einer oder mehreren Maschinen (705), um einen Herstellungsprozess gemäß der endgültigen Funktion auszuführen, umfasst.

3. Verfahren nach Anspruch 1, wobei
die Bestellung mehrere Bestellungen umfasst, die von mehreren Agenten ausgestellt wurden.

**4.** Verfahren nach Anspruch 1, wobei
die Ergebnisse der Simulation einen Zustand der Bestellung, die simuliert wird, und einen Zustand einer Fabrikhalle (701), die die Bestellung verarbeitet, umfassen.

**5.** Nichttransitorisches computerlesbares Medium, in dem Befehle zum Simulieren von Prozessen in Fabrikfertigungslinien gespeichert sind, wobei die Befehle die folgenden Schritte umfassen:

Bestimmen durch einen Prozessor (810) einer Funktion für interne Prozesse, wobei die Funktion aus einem aktuellen Produktionsstatus der einen oder der mehreren Maschinen einer Fabrikhalle (701) erzeugt wird,

a) Ausführen durch den Prozessor (810) einer Simulation, um die Verarbeitung von Ereignissen der Fabrikfertigungslinien unter Berücksichtigung gesammelter historischer Daten zu simulieren,
b) Ausführen durch den Prozessor (810) mehrerer Durchläufe eines Prozesses für maschinelles Lernen im Hinblick auf Ergebnisse der Simulation, um die Funktion gemäß einer Bewertungsfunktion zu aktualisieren, wobei die Bewertungsfunktion eine Kostenfunktion ist, die auf der Grundlage eines angebotenen Fälligkeitstermins und eines tatsächlichen Liefertermins gemäß der Bestimmung durch die Simulation gewichtet ist,

iteratives Ausführen durch den Prozessor der Schritte a) und b), bis eine endgültige Funktion bestimmt worden ist, wobei das Ergebnis jeder Iteration der Simulation eine Belohnung ist, die durch Bilden eines Negativen der Kostenfunktion bestimmt wird, wobei die Kostenfunktion als $\omega_J L_j + \omega_E E_j + \omega_T T_j$ definiert ist, wobei $\omega_J$, $\omega_E$ und $\omega_T$ Konstanten sind, die im Voraus definiert sind, $L_j$ eine Vorlaufzeit eines Auftrags ist, $E_j$ eine Verfrühung des Auftrags ist und $T_j$ eine Verspätung des Auftrags ist, und
Ausgeben der endgültigen Funktion.

**6.** Nichttransitorisches computerlesbares Medium nach Anspruch 5, wobei

die internen Prozesse Herstellungsprozesse sind und
das Ausgeben der endgültigen Funktion ein Antworten auf eine Bestellung mit einer Fälligkeitsterminstrategie und ein Ausliefern der endgültigen Funktion zu einer oder mehreren Maschinen (705), um einen Herstellungsprozess gemäß der endgültigen Funktion auszuführen, umfasst.

**7.** Nichttransitorisches computerlesbares Medium nach Anspruch 5, wobei
die Bestellung mehrere Bestellungen umfasst, die von mehreren Agenten ausgestellt wurden.

**8.** Nichttransitorisches computerlesbares Medium nach Anspruch 5, wobei
die Ergebnisse der Simulation einen Zustand der Bestellung, die simuliert wird, und einen Zustand einer Fabrikhalle (701), die die Bestellung verarbeitet, umfassen.

**9.** System, das Folgendes umfasst:

eine oder mehrere Maschinen (705) in einer Fabrikhalle (701) und
eine Vorrichtung, die durch eine oder mehrere programmierbare Logiksteuereinheiten (PLCs) an die eine oder die mehreren Maschinen (705) kommunikationstechnisch gekoppelt ist, wobei die Vorrichtung Folgendes umfasst:

einen Prozessor (810), der konfiguriert ist zum
Bestimmen einer Funktion für interne Prozesse, wobei die Funktion aus einem aktuellen Produktionsstatus der einen oder der mehreren Maschinen einer Fabrikhalle (701) erzeugt wird,

a) Ausführen einer Simulation, um die Verarbeitung von Ereignissen der Fabrikfertigungslinien unter Berücksichtigung gesammelter historischer Daten zu simulieren,
b) Ausführen mehrerer Durchläufe eines Prozesses für maschinelles Lernen im Hinblick auf Ergebnisse der Simulation, um die Funktion gemäß einer Bewertungsfunktion zu aktualisieren, wobei die Bewertungsfunktion eine Kostenfunktion ist, die auf der Grundlage eines angebotenen Fälligkeitstermins und eines tatsächlichen Liefertermins gemäß der Bestimmung durch die Simulation gewichtet ist,

iteratives Ausführen der Schritte a) und b), bis eine endgültige Funktion bestimmt worden ist, wobei das Ergebnis jeder Iteration der Simulation eine Belohnung ist, die durch Bilden eines Negativen der Kostenfunktion bestimmt wird, wobei die Kostenfunktion als $\omega_J L_j + \omega_E E_j + \omega_T T_j$ definiert ist, wobei $\omega_J$, $\omega_E$ und $\omega_T$ Konstanten sind, die im Voraus definiert sind, $L_j$ eine Vorlaufzeit eines Auftrags ist, $E_j$ eine Verfrühung des Auftrags ist und $T_j$ eine Verspätung des Auftrags ist, und

Ausgeben der endgültigen Funktion.

10. Herstellungssystem nach Anspruch 9, wobei

die internen Prozesse Herstellungsprozesse sind und
der Prozessor (810) konfiguriert ist, die endgültige Funktion in Reaktion auf eine Bestellung durch Antworten auf die Bestellung mit einer Fälligkeitsterminstrategie und ein Ausliefern der endgültigen Funktion zu der einen oder den mehreren Maschinen (705) auszugeben, um einen Herstellungsprozess gemäß der endgültigen Funktion auszuführen.

11. Herstellungssystem nach Anspruch 9, wobei
die Bestellung mehrere Bestellungen umfasst, die von mehreren Agenten ausgestellt wurden.

12. Herstellungssystem nach Anspruch 9, wobei
die Ergebnisse der Simulation einen Zustand der Bestellung, die simuliert wird, und einen Zustand der Fabrikhalle (701), die die Bestellung verarbeitet, umfassen.


**Revendications**

1. Procédé mis en oeuvre sur ordinateur pour simuler des processus dans des lignes de production d'usine, comprenant les étapes consistant à :

déterminer (S300), via un processeur (810), une fonction pour processus internes, dans lequel la fonction est générée à partir d'un état de production actuel d'une ou de plusieurs machines d'un atelier d'usine (701),

a) en effectuant (S301), via le processeur (810), une simulation pour simuler des événements de traitement des lignes de production d'usine à l'égard de données historiques collectées,
b) en effectuant (S302), via le processeur (810), des exécutions multiples d'un processus d'apprentissage automatique à l'égard de résultats de la simulation pour mettre à jour la fonction en accord avec une fonction d'évaluation, dans lequel

la fonction d'évaluation est une fonction de coût qui est pondérée sur la base d'une date d'échéance notée et d'une date de livraison, comme déterminé par la simulation,
exécuter de manière itérative (S303), via le processeur (810), les étapes a) et b) jusqu'à ce qu'une fonction finalisée soit déterminée, dans lequel le résultat de chaque itération de la simulation est une récompense déterminée en prenant une valeur négative de la fonction de coût, dans lequel la fonction de coût est définie comme $\omega_J L_j + \omega_E E_j + \omega_T T_j$, où $\omega_J$ et $\omega_E$ et $\omega_T$ sont des constantes définies à l'avance, $L_j$ est un délai d'exécution d'une tâche, $E_j$ est une précocité de la tâche et $T_j$ est un retard de la tâche, et
sortir (S304) la fonction finalisée.

2. Procédé selon la revendication 1, dans lequel
les processus internes sont des processus de fabrication, et dans lequel l'étape consistant à sortir (S304) la fonction finalisée comprend de répondre à un ordre avec un arrangement de date d'échéance et d'envoyer la fonction finalisée à une ou plusieurs machines (705) pour effectuer un processus de fabrication en accord avec la fonction finalisée.

3. Procédé selon la revendication 1, dans lequel
l'ordre comprend des ordres multiples issus d'agents multiples.

4. Procédé selon la revendication 1, dans lequel
les résultats de la simulation comprennent un état de l'ordre tel que simulé et un état d'un atelier d'usine (701) traitant l'ordre.

**5.** Support non transitoire lisible sur ordinateur, stockant des instructions destinées à des processus de simulation dans des lignes de production d'usine, les instructions comprenant les étapes consistant à :

déterminer, via un processeur (810), une fonction pour processus internes, dans lequel la fonction est générée à partir d'un état de production actuel d'une ou de plusieurs machines d'un atelier d'usine (701),

a) en effectuant, via le processeur (810), une simulation pour simuler des événements de traitement des lignes de production d'usine à l'égard de données historiques collectées,
b) en effectuant, via le processeur (810), des exécutions multiples d'un processus d'apprentissage automatique à l'égard de résultats de la simulation pour mettre à jour la fonction en accord avec une fonction d'évaluation, dans lequel la fonction d'évaluation est une fonction de coût qui est pondérée sur la base d'une date d'échéance notée et d'une date de livraison réelle, comme déterminé par la simulation,

exécuter de manière itérative, via le processeur, les étapes a) et b) jusqu'à ce qu'une fonction finalisée soit déterminée, dans lequel le résultat de chaque itération de la simulation est une récompense déterminée en prenant une valeur négative de la fonction de coût, dans lequel la fonction de coût est définie comme $\omega_J L_j + \omega_E E_j + \omega_T T_j$, où $\omega_J$ et $\omega_E$ et $\omega_T$ sont des constantes définies à l'avance, $L_j$ est un délai d'exécution d'une tâche, $E_j$ est une précocité de la tâche et $T_j$ est un retard de la tâche, et
sortir la fonction finalisée.

**6.** Support non transitoire lisible sur ordinateur selon la revendication 5, dans lequel
les processus internes sont des processus de fabrication, et dans lequel l'étape consistant à sortir la fonction finalisée comprend de répondre à un ordre avec une politique de date d'échéance et d'envoyer la fonction finalisée à une ou plusieurs machines (705) pour effectuer un processus de fabrication en accord avec la fonction finalisée.

**7.** Support non transitoire lisible sur ordinateur selon la revendication 5, dans lequel
l'ordre comprend des ordres multiples issus d'agents multiples.

**8.** Support non transitoire lisible sur ordinateur selon la revendication 5, dans lequel
les résultats de la simulation comprennent un état de l'ordre tel que simulé et un état d'un atelier d'usine (701) traitant l'ordre.

**9.** Système, comprenant :

une ou plusieurs machines (705) sur un atelier d'usine (701), et
un appareil couplé en communication auxdites une ou plusieurs machines (705) via un ou plusieurs automates programmables industriels (PLC, Programmable Logic Controller), l'appareil comprenant :
un processeur (810), configuré pour :

déterminer une fonction pour processus internes, dans lequel la fonction est générée à partir d'un état de production actuel desdites une ou plusieurs machines d'un atelier d'usine (701),

a) en effectuant une simulation pour simuler des événements de traitement des lignes de production d'usine à l'égard de données historiques collectées,
b) en effectuant des exécutions multiples d'un processus d'apprentissage automatique à l'égard de résultats de la simulation pour mettre à jour la fonction en accord avec une fonction d'évaluation, dans lequel la fonction d'évaluation est une fonction de coût qui est pondérée sur la base d'une date d'échéance notée et d'une date de livraison réelle, comme déterminé par la simulation,

exécuter de manière itérative les étapes a) et b) jusqu'à ce qu'une fonction finalisée soit déterminée, dans lequel le résultat de chaque itération de la simulation est une récompense déterminée en prenant une valeur négative de la fonction de coût, dans lequel la fonction de coût est définie comme $\omega_J L_j + \omega_E E_j + \omega_T T_j$, où $\omega_J$ et $\omega_E$ et $\omega_T$ sont des constantes définies à l'avance, $L_j$ est un délai d'exécution d'une tâche, $E_j$ est une précocité de la tâche et $T_j$ est un retard de la tâche, et
sortir la fonction finalisée.

**10.** Système de fabrication selon la revendication 9, dans lequel

les processus internes sont des processus de fabrication, et dans lequel

le processeur (810) est configuré pour sortir la fonction finalisée en réponse à un ordre en répondant à l'ordre avec une politique de date d'échéance et en envoyant la fonction finalisée auxdites une ou plusieurs machines (705) pour effectuer un processus de fabrication en accord avec la fonction finalisée.

11. Système de fabrication selon la revendication 9, dans lequel
l'ordre comprend des ordres multiples issus d'agents multiples.

12. Système de fabrication selon la revendication 9, dans lequel
les résultats de la simulation comprennent un état de l'ordre tel que simulé et un état de l'atelier d'usine (701) traitant l'ordre.

Customer 100

Order arrive

Reply due date

Scheduler 110

Due date quotation 111

Scheduling 112

Release job

Shop floor 120

Process 1 121

...

Process N 121

Refer

Schedule (Sequence) 130

j1  j2  j3

j4  j1  j5

j5  j6

Scheduling

Deliver

FIG. 1

Due date production scheduling (DDPS) system 240

Order history 241

Production history 242

DDPS Optimization 250

Policy learning 251

Policy application 252

Quotation policy 260

Scheduling policy 261

Client 270

Existing environment

Factory 210

Operators

Machines

Products

ERP 220

Orders 221

MES 230

Production status 231

FIG. 2

Collect order history and production status 300

↓

Build a simulation for order arriving and production 301

↓

Set initial policies 302

↓

Update policies with multiple runs of simulations 303

↓

Output updated policies 304

FIG. 3

**Agents 410**

Due date quotation

/ Quotation policy /

Production scheduling

/ Scheduling policy /

**Quote due date**

Simulation environment 400

Order

Shop floor

**Schedule**

**Feedback**

FIG. 4

## Order List 501

| | Order ID | Received | Customer | Product | Quantity | Size | Requested Due |
|---|---|---|---|---|---|---|---|
| ● | US-2018-01103 | 2019/08/20 | A | Prd 1 | 100 | Large | 2019/09/20 |
| ○ | US-2018-01104 | 2019/08/20 | B | Prd 2 | 70 | Small | 2019/09/30 |

## Quoted Due Date 502

| Quoted Due | Expected Lead time | Scheduled release | Expected completed | |
|---|---|---|---|---|
| 2019/09/21 | 10 days | 2019/09/10 | 2019/09/10 | |

FIG. 5

## Machine status <u>601</u>

| Process | Machine Available | # Jobs waiting |
|---------|-------------------|----------------|
| P010 | M010 | 3 |
| P020 | No | 3 |
| P030 | No | 2 |
| ••• | ••• | ••• |

## Jobs in M010 Queue <u>602</u>

| Order ID | Product | Quantity | Quoted Due |
|----------|---------|----------|------------|
| US_2018-00903 | Prd0023 | 50 | 2019/09/22 |
| US_2018-00904 | Prd0024 | 70 | 2019/09/20 |
| US_2018-00905 | Prd0023 | 30 | 2019/10/01 |
| ••• | | | ••• |

## Dispatching <u>603</u>

Next job for Machine M010

| Order ID | Quoted time | Process |
|----------|-------------|---------|
| US_2018-01103 | 2019/09/22 | P010 |

[ Cancel ]  [ Dispatch ]

FIG. 6

FIG. 7

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019040999 A1
- WO 2016207901 A1
- US 201801103 B
- US 201801104 B
- US 201801105 B